# EUROPEAN PATENT APPLICATION

(11) **EP 1 832 550 A1**
(43) Date of publication of application: **12.09.2007**
(21) Application number: 06075578.2
(22) Date of filing: 10.03.2006
(51) Int. Cl.: B81B 3/00, H01H 1/00

(54) **Electrostatic actuation method and electrostatic actuator with integral electrodes for microelectromechanical systems**

(71) Applicant: SEIKO EPSON CORPORATION, Shinjuku-ku Tokyo 163-0811 (JP)
(72) Inventor: Carmona, Manuel, Epson Europe Electronics GmbH, 08190 Sant Cugat del Vallés Barcelona (ES); Pallares, Jofre, Epson Europe Electronics GmbH, 08190 Sant Cugat del Vallés Barcelona (ES)
(74) Representative: Carvajal y Urquijo, Isabel

(57) **Abstract**

An electrostatic actuation method for micro-electromechanical systems, comprising:
- providing a first electrode (10) integral to a movable part (100) of the micro-electromechanical system, and
- providing at least a second electrode (20, 20') also integral to the same movable part (100) of the micro-electromechanical system, there being a gap (40) between said first and second electrodes, where said first and second electrodes are electrically isolated from each other using an electrically non-conductive material (30),
- inducing a charge in the electrodes which generates a force between the electrodes, said force acting between the electrodes causing the deformation of the movable part of the micro-electromechanical system.

The invention also relates to an electrostatic actuator with integral electrodes for micro-electromechanical systems.

## Description

### Field of the invention

The invention relates to the actuation of microelectromechanical systems (MEMS).

### Background of the invention

Microelectromechanical systems (MEMS) are among the most promising technologies for implementing low-cost, low-power components for radio-frequency RF applications. The micrometric scale of these devices and the possibility of integration can avoid the problem of the large area occupied by the passive components of current RF systems, replacing all of them by a single MEMS chip or integrating them into the processing chip of the system.

Many actuators built with these technologies have already been developed, although only some of them have found a place in the market. A key point of these devices consists on the performance of the actuation method for every specific device. Many actuation principles are used for actuating MEMS: electrothermal, electrostatic, magnetic, piezoelectric, etc. Nowadays, one of the most used actuation principles in MEMS is the electrostatic actuation. In electrostatic actuation a voltage is applied to two layered conductors (electrodes) to induce charge on the conductors, and the force acting between the induced charges is used as an actuating source. One of its advantages is the large force achieved for small gaps. Nevertheless, a general disadvantage is usually the need for a large area, which affects negatively many properties of the devices by reducing speed, decreasing reliability and also increasing costs per area.

Up to now, most of the microdevices which use electrostatic actuation are based in the use of an electrode at a movable part (like a cantilever beam or a bridge consisting of a beam anchored at both ends) of the device and a fixed electrode at the substrate.

The main inconvenience of these devices is usually the small force actuating over the movable electrode when the gap is large. Due to this fact, these devices require a very large area to increase the force, thus significantly reducing their speed due to the increased mass, and increasing the damping. This problem is at present partially solved by different methods: adding holes to the movable device to decrease damping (but also reducing the total force); increasing the area to increase the force (but decreasing their speed and making them prone to stiction problems); reducing the gap (again increasing stiction problems and usually degrading important device parameters); reducing thickness.

In the way of an example, European patent application published EP-1354848 relates to micro-electromechanical systems, and more specifically to a micro-electromechanical system having a movable mass which is supported and moved by a flexure having an integrally formed actuator. The device disclosed in this document uses a single electrically conductive material to form both actuating electrodes; also, the device is restricted to an operation with repulsing forces.

Document US 2003/015936 A1 discloses an electrostatic actuator. A multilayered auxiliary electrode is further arranged between main electrode and actuating body, and positive charge or negative charge is applied to main electrode, respective auxiliary electrodes, and actuating body such that electrostatic attractive force is generated between auxiliary electrodes adjacent to the main electrode, between adjacent auxiliary electrodes, and between auxiliary electrodes adjacent to the actuating body.

### Summary of the invention

The invention refers to an electrostatic actuation method according to claim 1, to an actuator according to claim 12 and to a microswitch according to claims 24 or 25. Preferred embodiments of the method and electrostatic actuator are defined in the dependent claims.

The invention consists on the fabrication of both electrodes of an electrostatic actuation on the movable part of a device.

A first aspect of the invention relates to an electrostatic actuation method for micro-electromechanical systems, comprising:
- providing a first electrode integral to a movable part of the micro-electromechanical system, and
- providing at least a second electrode on the same movable part of the micro-electromechanical system, there being a gap between said first and second electrodes, where said first and second electrodes are electrically isolated from each other using an electrically non-conductive material,
- inducing a charge in the electrodes which generates a force between the electrodes, said force acting between the electrodes causing the deformation of the movable part of the micro-electromechanical system.

The electrically non-conductive material may be provided at any portion along the length of the second electrode, electrically isolating it from the first electrode.

Thus, according to the present invention, an electrostatic actuation method is used in order to increase the force applied over the movable part of the device to which the actuation method is applied to during the whole displacement swing of the device. Also, a reduction of the actuation area and voltage are achieved thanks to the large force obtained. An increase of the speed is also achieved due to the small mass needed and the large force obtained. Therefore, a device with very good performance properties can be obtained using the actuation method of the present invention.

Preferably, the actuation method further comprises providing the electrically non-conductive material on at least a first portion of the second electrode. This first portion may be a first end portion of the second electrode; this way, the second or actuating electrode is of a beam-like type.

It may also comprise providing the electrically non-conductive material also on a at least second portion of the second electrode. This second portion may be also a second end portion of the second electrode, being said second end opposite to the first end; this way, the second or actuating electrode has a bridge-like structure.

The method of the invention preferably provides two or more of said second or actuating electrodes along the length of the movable part.

It may also comprise providing a plurality of second electrodes on the same side along the length of the movable part.

These two or more second electrodes may be of the beam-like type or of the bridge-like type.

The charges induced in the first and second electrodes may be of the same sign, thereby causing a repulsing force between the electrodes. Or said force can also be an attractive force generated by applying a voltage difference between said first and second electrodes.

Preferably, said second electrode is, at the most, as long as the first electrode is.

A second aspect of the invention relates to an electrostatic actuator for micro-electromechanical systems MEMS, which comprises at least a pair of first and second electrodes, the electrostatic actuator is characterised in that
- said first electrode is integral to a movable part of the micro-electromechanical system, and
- said second electrode is integral to the same movable part of the micro-electromechanical system, there being a gap between said first and second electrodes, where said first and second electrodes are electrically isolated from each other with the use of an electrically non-conductive material,
wherein in response to a charge induced in the electrodes a force is generated between the electrodes, causing the deformation of the movable part of the micro-electromechanical system.

The voltage for actuating said first and second electrodes may be carried by the movable part. Or it may be carried by one or more additional layers; in the latter case, said one or more additional layers are preferably flexible, such that they do affect as less as possible the movement of the movable/flexible part. This means that the deflection of the movable part exerted by the actuation will be of the same order magnitude than the deflection of the device without the additional layers.

Said electrically non-conductive material may isolate the second electrode from the first electrode on at least a first portion along the length of the second electrode. This first portion may be a first end portion, there forming a beam-like type for the second electrode.

Said electrically non-conductive material may further isolate the second electrode from the first electrode also on at least a second portion of the second electrode. This second portion may be a second end portion, being said second end opposite to the first end, there forming a bridge-like type for the second electrode.

According to a preferred embodiment, the electrostatic actuator comprises at least two second electrodes along the length of the movable part.

The electrostatic actuator may comprise a plurality of second electrodes on the same side, but either side, along the length of the movable part. Or they can be provided at both sides over the length of the movable part, in which case, preferably the two or more second electrodes on the same side of the movable part are of the same type.

These two or more second electrodes may be of the beam-like type or of the bridge-like type.

The electrically non-conductive material preferably permits the deformation of the movable part.

The electrostatic actuation method of the present invention can be used for fabricating MEMS with optimized performance properties. These properties are: low actuation voltage, large displacement, high speed and small device area. Low cost devices can be fabricated due to the area reduction and the ease of fabrication. Therefore, the range of applications is large: RF MEMS, microfluidics, microsensors and microactuators, etc.

Specific application devices are: microswitches, micromirrors, positioning systems, microvalves, etc.

### Short description of the drawings

A series of drawings aiding to better understand the invention and which are expressly related to preferred embodiments of said invention, representing a nonlimiting example thereof, is very briefly described below.

Figure 1 shows a cross section of a first device illustrating the electrostatic actuation principle of the present invention.

Figure 2 shows a cross section of a second device illustrating the electrostatic actuation principle of the present invention.

Figure 3 shows a cross section of a third device illustrating the electrostatic actuation principle of the present invention.

Figure 4 shows a cross section of a fourth device illustrating the electrostatic actuation principle of the present invention.

Figure 5 shows a top and a front view of a first microswitch using the electrostatic actuation method of the present invention.

Figure 6 shows a top and a front view of a second microswitch using the electrostatic actuation method of the present invention.

Figure 7 shows a top and a front view of a third microswitch using the electrostatic actuation method of the present invention.

### Detailed description of the drawings

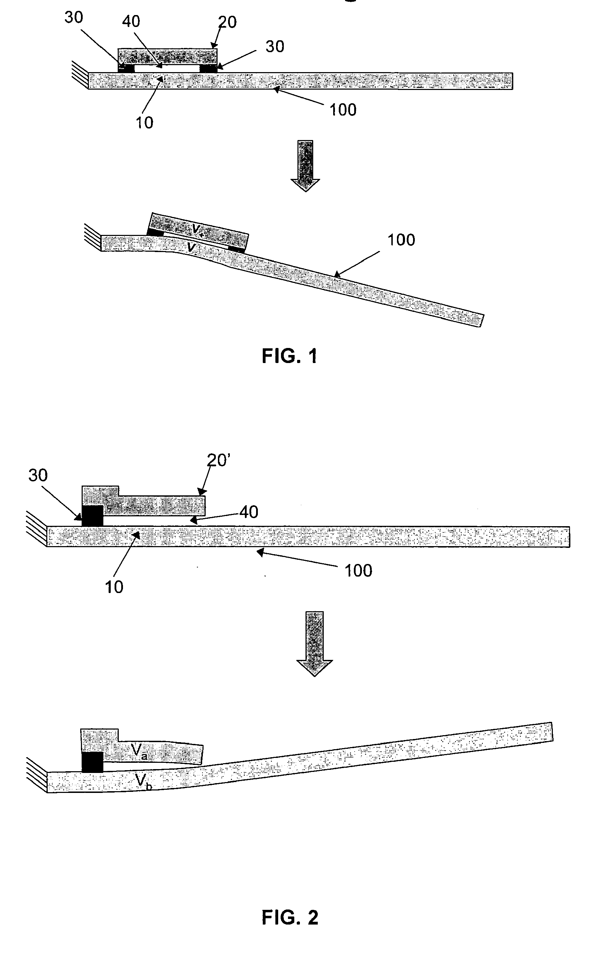

Figure 1 shows a cross section of a first possible embodiment of an electrostatic actuator according to the present invention, and it also illustrates the electrostatic actuation principle of the present invention.

The electrostatic actuator has a first electrode 10 which forms an integral part of the movable and flexible part 100 (for example, a beam) of the device to which the electrostatic actuator will be applied. It also has a second electrode 20 which is built forming also an integral part of that same flexible part 100 over two electrically isolating supports 30. There is an air gap or layer of soft dielectric material 40 between the first and second electrodes. In the case of the soft dielectric material, it must be soft enough to allow the deformation of the device.

That is, in this first embodiment, an actuation structure 10, 20, 30 (like a bridge) with a small gap between the electrodes is built on the movable part 100 of the device.

Applying a voltage difference between both electrodes generates an attractive force of the electrode regions, causing the deformation of the movable part.

Then, using supports 30 that permit the deformation of the flexible structure, by means of soft support material or just by geometrical design of the supports, the complete flexible structure will be bent.

The direction of the bending will depend on the side where the second electrode ("actuating electrode") has been located.

As indicated, the electrostatic actuation principle is illustrated in Figure 1 for the specific case of a beam. Due to the large force obtained for a small gap, a small actuation area can be enough for many applications. In any case, for higher forces, an increase of the area at the actuation regions of the devices and/or the addition of parallel actuators can also be implemented.

The voltages for actuating both electrodes can be carried by the flexible part itself (when it is electrically conductive), or by using additional layers. In the latter case, the additional electrical connections should affect as less as possible the movement of the movable part 100 in order to maximize the displacement.

This actuation principle can be used for out-of-plane and in-plane displacement of the movable part.

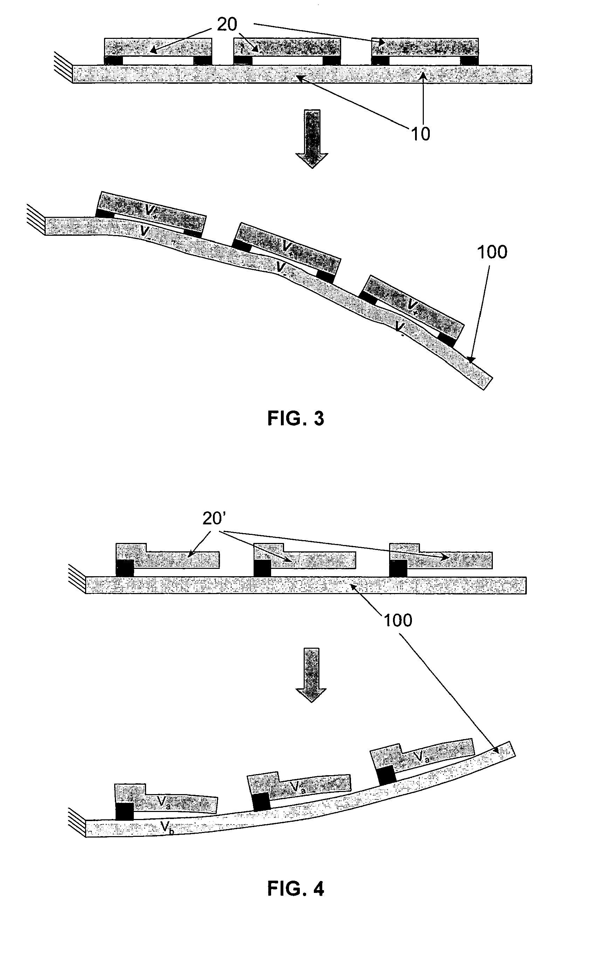

Figure 2 shows a second embodiment for the actuator of the invention, where instead of having a bridge like structure, the second or actuating electrode consists of a beam 20', which is electrically isolated from the first electrode 10 (and therefore, electrically isolated from the movable part 100) by a single electrically isolating support 30 and gap 40.

Again, the bottom part of figure 2 shows the actuation principle of the invention: a charge is induced on the electrodes, and the force acting between the induced charges is used as an actuating source for the micro-electromechanical system.

The gap 40 can be achieved by several known methods, such as surface micromachining process by removing thermal oxide between polysilicon layers and photolithographic definition of the gap.

Figure 3 shows a further embodiment of the invention, where an array of second or actuating electrodes 20 are used over the length of the movable part 100 of the device.

Additionally, the actuating electrodes can be located on any side to achieve displacement of the device in the upward or downward direction (or left or right for the in-plane displacement).

Figure 4 shows still a further embodiment of the invention, where an array of second or actuating electrodes 20' are used over the length of the movable part 100 of the device.

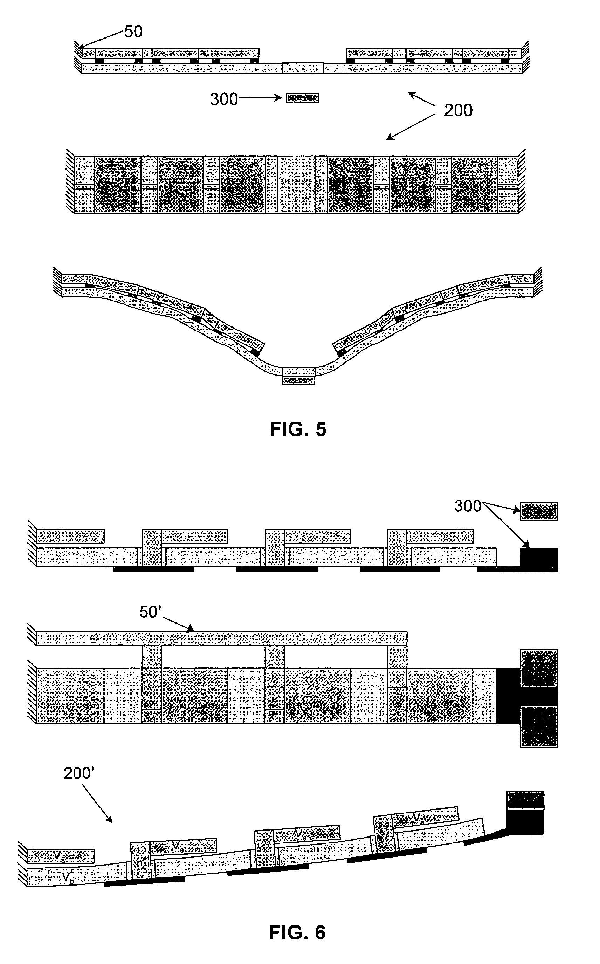

One possible application of the present invention is a microswitch, which is shown in figure 5: the switch 200 has an array of actuating electrodes 20. When a voltage difference is applied -via the flexible connections 50 -between the array of second electrodes and the first electrodes (which are integral to the switch), the switch makes contact with the contact pad 300.

In this case, a large deflection can be obtained with a low voltage and keeping a high back restoration force when the force is released, which can avoid the stiction problems after contact is produced.

Figure 6 shows a second microswitch 200' formed by an array of actuating electrodes 20' (with single support). In this embodiment, there is also an electrical connection 50' for the actuating electrodes 20'.

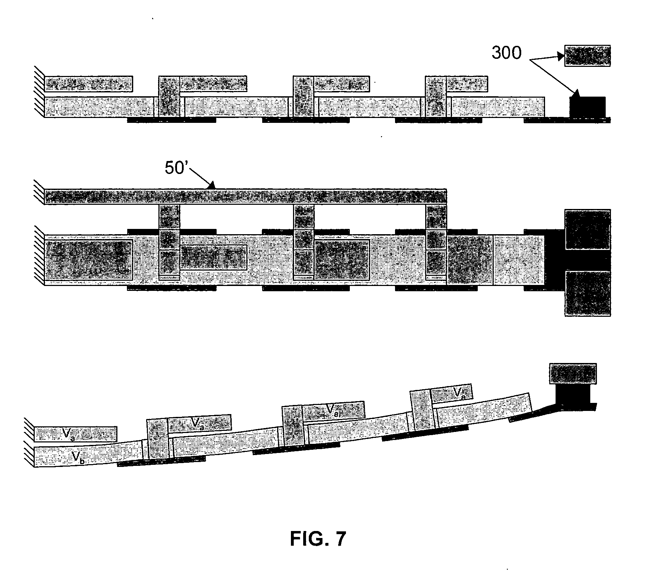

Although the embodiments shown in figures 3, 4, 5 and 6 include actuating electrodes all having equal dimensions within the same device, it is all possible that such actuating electrodes 20, 20' have different dimensions. Indeed, as shown in figure 7, the supports, the first and second electrodes need not have equal dimensions, but may be of different width, length or thickness.

## Claims

1. An electrostatic actuation method for micro-electromechanical systems, comprising:
- providing a first electrode (10) integral to a movable part (100) of the micro-electromechanical system, and
- providing at least a second electrode (20, 20') also integral to the same movable part (100) of the micro-electromechanical system, there being a gap (40) between said first and second electrodes, where said first and second electrodes are electrically isolated from each other using an electrically non-conductive material (30),
- inducing a charge in the electrodes which generates a force between the electrodes, said force acting between the electrodes causing the deformation of the movable part of the micro-electromechanical system.

2. Electrostatic actuation method according to claim 1, wherein it comprises providing the electrically non-conductive material (30) on at least a first portion along the length of the second electrode.

3. Electrostatic actuation method according to claim 2, wherein said first portion is a first end portion of the second electrode.

4. Electrostatic actuation method according to any of claims 2-3, wherein it comprises providing the electrically non-conductive material (30) also on at least a second portion of the second electrode.

5. Electrostatic actuation method according to claims 3-4, wherein said second portion is a second end portion of the second electrode, being said second end opposite to the first end.

6. Electrostatic actuation method according to any previous claim, wherein it comprises providing at least two second electrodes (20, 20') along the length of the movable part.

7. Electrostatic actuation method according to any previous claim, wherein it comprises providing a plurality of second electrodes on the same side along the length of the movable part.

8. Electrostatic actuation method according to claims 6 or 7, wherein it comprises providing at least two second electrodes (20, 20') of the type as defined in claims 2 or 3 and/or of the type defined in claims 4 or 5.

9. Electrostatic actuation method according to any previous claim, wherein the charges induced are of the same sign thereby causing a repulsing force between the electrodes.

10. Electrostatic actuation method according to any of claims 1-6, wherein the charges induced are of opposite sign thereby causing an attractive force between the electrodes.

11. Electrostatic actuation method according to any previous claim, wherein said second electrode is, at the most, as long as the first electrode is.

12. An electrostatic actuator for micro-electromechanical systems MEMS, which comprises at least first and second electrodes (10, 20, 20'),
the electrostatic actuator is **characterised in that**
- said first electrode (10) is integral to a movable part (100) of the micro-electromechanical system, and
- said second electrode (20, 20') is integral to the same movable part (100) of the micro-electromechanical system, there being a gap (40) between said first and second electrodes, where said first and second electrodes are electrically isolated from each other with the use of an electrically non-conductive material (30),
wherein in response to a charge induced in the electrodes a force is generated between the electrodes, causing the deformation of the movable part of the micro-electromechanical system.

13. Electrostatic actuator according to claim 12, wherein the voltage for actuating said first and second electrodes is carried by the movable part.

14. Electrostatic actuator according to claim 12, wherein the voltage for actuating said first and second electrodes is carried by one or more additional layers.

15. Electrostatic actuator according to claim 14, wherein said one or more additional layers are flexible, such that they do affect as less as possible the movement of the movable part.

16. Electrostatic actuator according to any of claims 12-15, wherein said electrically non-conductive material (30) isolates the second electrode from the first electrode on at least a first portion along the length of the second electrode.

17. Electrostatic actuator according to claim 16, wherein said first portion is a first end portion of the second electrode.

18. Electrostatic actuator according to any of claims 16-17, wherein said electrically non-conductive material (30) isolates the second electrode from the first electrode also on at least a second portion of the second electrode.

19. Electrostatic actuator according to claims 17 and 18, wherein said second portion is a second end portion of the second electrode, being said second end opposite to the first end.

20. Electrostatic actuator according to any of claims 12-19, wherein it comprises at least two second electrodes (20, 20') along the length of the movable part.

21. Electrostatic actuator according to any of claims 12-20, wherein it comprises a plurality of second electrodes on the same side of the movable part.

22. Electrostatic actuator according to claims 20 or 21, wherein said at least two second electrodes are of the type defined in claims 16 or 17 and/or of the type defined in claims 18 or 19.

23. Electrostatic actuator according to any of claims 12-22, wherein said electrically non-conductive material permits the deformation of the movable part.

24. Microswitch which uses the electrostatic actuation method of any of claims 1-11.

25. Microswitch which includes an electrostatic actuator according to any of claims 12-23.
